# EUROPÄISCHE PATENTSCHRIFT

(11) **EP 0 464 245 B1**
(45) Veröffentlichungstag und Bekanntmachung des Hinweises auf die Patenterteilung: **11.10.1995**
(21) Anmeldenummer: 90112782.9
(22) Anmeldetag: 04.07.1990
(51) Int. Cl.: H03K 3/2897

(54) **Schaltungsanordnung für einen Pegelwandler zum Umwandeln von TTL-Eingangssignalen in ECL-Ausgangssignale**
Circuit arrangement for a level converter from TTL input signals to ECL output signals
Montage pour un convertisseur de niveaux entre signaux d'entrée TTL et signaux de sortie ECL

(43) Veröffentlichungstag der Anmeldung: 08.01.1992
(73) Patentinhaber: SIEMENS AKTIENGESELLSCHAFT, 80333 München (DE)
(72) Erfinder: Özoguz-Geissler, Nedim, Dipl.-Ing., D-8012 Ottobrunn (DE)

(56) Entgegenhaltungen:
- FR-A- 2 155 355
- GB-A- 1 308 012
- LU-A- 57 469
- NL-A- 270 043
- NL-A- 8 701 406
- US-A- 3 573 495
- IBM TECHNICAL DISCLOSURE BULLETIN, Band 10, Nr. 1, Juni 1976, Seiten 79-80,Armonk, New York, US; F.B. CHEW: "Variable hysteresis amplifier-shaper"

## Beschreibung

### Schaltungsanordnung für einen Pegelwandler zum Umwandeln von TTL-Eingangssignalen in ECL-Ausgangssignale

Die Erfindung betrifft eine Schaltungsanordnung für einen Pegelwandler zum Umwandeln von TTL-Eingangssignalen in ECL-Ausgangssignale.

In der integrierten Schaltungstechnik hat sich unter anderem die sogenannte Stromschaltertechnik (CML = current mode logic) wegen ihrer sehr kleinen Schaltzeiten durchgesetzt. Die verbreiteste Schaltkreisfamilie der Stromschaltertechnik ist unter der Abkürzung ECL "emitter coupled logic" bekannt. Wegen ihrer hohen Schaltgeschwindigkeit findet die ECL-Schaltungstechnik beispielsweise in PLL-Schaltungen von Frequenzsyntheseeinrichtungen in Fernsehgeräten Anwendung. Dort wird eine quarzgenaue Umschaltung der Kanäle des Fernsehgerätes von einem Mikroprozessor gesteuert, der über Signalleitungen Daten an die PLL-Schaltung liefert.

Ein besonderes Problem in der ECL-Schaltungstechnik hierbei ist die wegen der hohen Schaltgeschwindigkeit erhöhte Störempfindlichkeit. Werden in der PLL-Schaltung die Daten des Mikroprozessors falsch übernommen, kann es zu Fehlfunktionen kommen. Besonders kritisch wird dies, wenn die Daten des Mikroprozessors als TTL-Signale "transistor transistor logic" vorliegen und der in ECL-Schaltungstechnik ausgeführten PLL zugeführt werden müssen. Die in TTL-Pegel beispielsweise über einen I²C-Bus vom Mikroprozessor ankommenden Daten mit einer Taktrate von beispielsweise 100 kHz sind jedoch oft von hochfrequenten Störsignalen überlagert. Dies kann dazu führen, daß die Daten in der PLL-Schaltung falsch übernommen werden, wodurch eine einwandfreie Funktion der PLL nicht mehr gewährleistet ist.

Es ist daher Aufgabe der Erfindung, eine Schaltungsanordnung für einen Pegelwandler der eingangs genannten Art anzugeben, mit der die Störempfindlichkeit deutlich verbessert werden kann.

Diese Aufgabe wird durch eine Schmitt-Trigger-Einrichtung mit Tiefpaßcharakter mit den folgenden Merkmalen gelöst:
- Die Schmitt-Trigger-Einrichtung weist einen an Bezugspotential liegenden Bezugspotentialanschluß, einen Eingangsanschluß zum Anlegen von TTL-Signalen und mindestens einen Ausgangsanschluß zum Abgreifen von pegelgewandelten ECL-Signalen auf,
- ein erster und zweiter Differenzverstärker weisen jeweils eine erste und zweite Eingangsklemme, eine erste und zweite Ausgangsklemme sowie zwei mit ihren Emitteranschlüssen an eine mit Bezugspotential verbundene Konstantstromquelle geschaltete Bipolartransistoren auf, deren Basisanschlüsse mit der ersten oder zweiten Eingangsklemme des jeweiligen Differenzverstärkers verbunden sind,
- die Ausgangsklemmen des ersten Differenzverstärkers sind mit den Eingangsklemmen des zweiten Differenzverstärkers verbunden,
- die erste Eingangsklemme des ersten Differenzverstärkers ist mit dem Eingangsanschluß verbunden,
- die erste Ausgangsklemme des zweiten Differenzverstärkers ist auf die zweite Eingangsklemme des ersten Differenzverstärkers rückgekoppelt,
- mindestens eine der beiden Ausgangsklemmen des zweiten Differenzverstärkers ist mit dem oder einem der Ausgangsanschlüsse verbunden,
- jeder der beiden Differenzverstärker weist zur Erhöhung der Eingangskapazitäten mindestens einen Kondensator auf und
- zwischen die erste Ausgangsklemme des zweiten Differenzverstärkers und die zweite Eingangsklemme des ersten Differenzverstärkers ist eine Einrichtung zur Pegelverschiebung geschaltet, die in ihrem Eingangs-Ausgangs-Signalpfad die Basis-Emitter-Strecke eines weiteren Bipolartransistors enthält.

Eine Realisierung für einen Schmitt-Trigger ist in der Offenlegungsschrift LU-57 469 beschrieben. Der Schmitt-Trigger enthält zwei aus Bipolartransistoren aufgebaute Differenzverstärker. Die Eingangsanschlüsse des zweiten Differenzverstärkers sind mit den Ausgangsanschlüssen des ersten Differenzverstärkers gekoppelt. Außerdem ist ein Ausgang des zweiten Differenzverstärkers direkt mit einem Eingang des ersten Differenzverstärkers verbunden. An einem weiteren Eingang des ersten Differenzverstärkers wird ein Signal eingekoppelt. Ein Ausgang des zweiten Differenzverstärkers dient zur Auskopplung des Ausgangsssignals.

Weiterbildungen der Erfindung sind Gegenstand der Unteransprüche.

Wesentlich bei der erfindungsgemäßen Schaltungsanordnung ist, daß die beiden Differenzverstärker der hochverstärkenden Schmitt-Trigger-Einrichtung Kondensatoren zur Erhöhung ihrer Eingangskapazitäten aufweisen und damit eine niedrige Eckfrequenz der Schaltungsanordnung erreicht wird. Somit wird die Geschwindigkeit der Bipolartransistoren reduziert. Damit ergibt sich eine Schaltungsanordnung für einen Pegelwandler von TTL-Pegel und ECL-Pegel mit Tiefpaßcharakteristik. Die Eckfrequenz kann durch entsprechende Auswahl der zur Erhöhung der Eingangskapazität vorgesehenen Kondensatoren ausgewählt werden.

Die Erfindung wird im folgenden anhand von zwei Figuren näher erläutert. Es zeigen:
- Figur 1: eine erfindungsgemäße Schaltungsanordnung eines Pegelwandlers und
- Figur 2: eine Schaltungsanordnung nach Figur 1 mit zusätzlichen Einrichtungen zur Pegelverschiebung sowie eine Eingangsstufe.

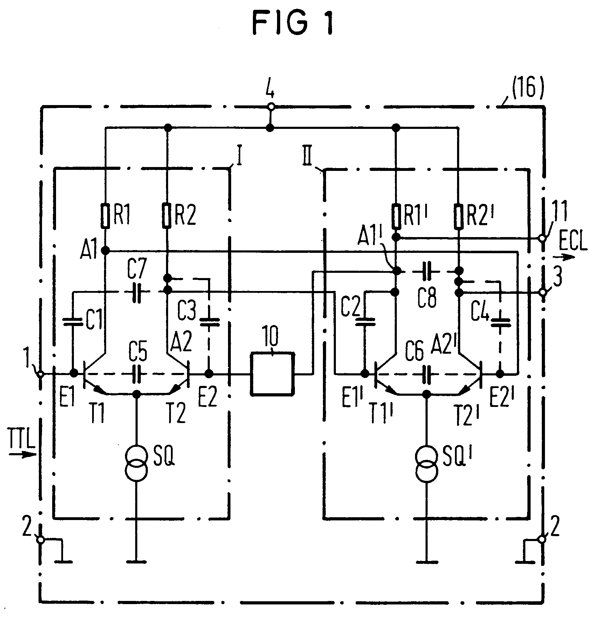

Figur 1 zeigt die erfindungsgemäße Schaltungsanordnung für einen Pegelwandler zum Umwandeln von TTL-Eingangssignalen in ECL-Ausgangssignale. Diese Schaltungsanordnung weist zwei zu einer Schmitt-Trigger-Einrichtung 16 verschaltete Differenzverstärker I, II mit jeweils zwei Bipolartransistoren T1, T2, T1′, T2′ auf. Die beiden Emitteranschlüsse der zwei Bipolartransistoren T1, T2 des ersten Differenzverstärkers I sind über eine Stromquelle SQ auf Bezugspotential geschaltet. Die Kollektoranschlüsse dieser beiden Bipolartransistoren T1, T2 sind über je einen Widerstand R1, R2 an einen Versorgungspotentialanschluß 4 zum Anlegen einer positiven Spannung geschaltet. Die Verbindungspunkte zwischen den Widerständen R1 und dem ersten Bipolartransistor T1 sowie zwischen dem Widerstand R2 und dem zweiten Bipolartransistor T2 stellen jeweils die Ausgangsklemme A1, A2 des Differenzverstärkers I dar, deren Eingangsklemmen E1, E2 die Basisanschlüsse der Bipolartransistoren T1, T2 bilden.

Ein dazu gleich aufgebauter zweiter Differenzverstärker II weist die beiden Bipolartransistoren T1′, T2′, eine Stromquelle SQ′ sowie zwei Widerstände R1′ und R2′ auf. Die Eingangsklemmen dieser zweiten Differenzverstärkerstufe II sind mit E1′ und E2′ und deren Ausgangsklemmen mit A1′ sowie A2′ bezeichnet.

Die erste Eingangsklemme E1 des ersten Differenzverstärkers I ist zugleich der Eingangsanschluß 1, an den das TTL-Signal angelegt werden muß. Der erste Differenzverstärker I und zweite Differenzverstärker II sind hintereinandergeschaltet, indem der Ausgangsanschluß A1 der ersten Differenzverstärkerstufe I mit der zweiten Eingangsklemme E2′ der zweiten Differenzverstärkerstufe II und die zweite Ausgangsklemme A2 der ersten Differenzverstärkerstufe I mit der ersten Eingangsklemme E1′ der zweiten Differenzverstärkerstufe II verbunden ist. Darüber hinaus ist der erste Ausgangsanschluß A1′ des zweiten Differenzverstärkers II über eine Einrichtung 10 zur Pegelverschiebung auf die zweite Eingangsklemme E2 des ersten Differenzverstärkers I rückgekoppelt. Diese Einrichtung 10 kann z. B. durch vier hintereinandergeschaltete Dioden gebildet sein, um einen TTL-Umschaltpunkt - der bei ca. 2,25 Volt liegt - zu realisieren. Mindestens eine der beiden Ausgangsklemmen A1′, A2′ des zweiten Differenzverstärkers II ist mit einem Ausgangsanschluß 3 verbunden. Es können auch beide Ausgangsklemmen A1′, A2′ mit je einem Ausgangsanschluß 3, 11 des Pegelwandlers in Verbindung stehen. Der Bezugspotentialanschluß ist in FIG 1 mit 2 bezeichnet. Die bis jetzt beschriebene Schaltungsanordnung in FIG 1 stellt eine hochverstärkende Schmitt-Trigger-Einrichtung (16) dar, deren Hysterese über die Widerstände R1′, R2′ eingestellt werden kann. Zur Spannungsversorgung der Schmitt-Trigger-Einrichtung 16 wird an den Versorgungspotentialanschluß 4 beispielsweise + 5 V und an den Bezugspotenialanschluß 2 OV der Spannungsquelle geschaltet.

Um die Störunempfindlichkeit des Pegelwandlers zu verbessern, wird erfindungsgemäß an jeden der beiden Differenzverstärker I, II zur Erhöhung ihrer Eingangskapazitäten mindestens ein Kondensator geschaltet. Im Ausführungsbeispiel nach FIG 1 erfolgt dies beispielhaft durch die beiden Kondensatoren C1, C2, von denen der Kondensator C1 zwischen die erste Eingangsklemme E1 und erste Ausgangsklemme A1 des ersten Differenzverstärkers I und der Kondensator C2 zwischen die erste Eingangsklemme E1′ und erste Ausgangsklemme A1′ des zweiten Differenzverstärkers geschaltet ist. Damit wird eine niedrige Eckfrequenz der Schmitt-Trigger-Eingrichtung 16 erreicht und die Schaltgeschwindigkeit der Bipolartransistoren T1 sowie T1′ reduziert. Die niedrige Eckfrequenz der Schmitt-Trigger-Einrichtung 16 und damit das Tiefpaßverhalten kann durch die Schaltelemente R1′, R2′ sowie die Kondensatoren C1 und C2 eingestellt werden. Die Erhöhung der Eingangskapazitäten der einzelnen Differenzverstärker I und II muß jedoch nicht gezwungenermaßen durch die eben beschriebene Anordnung der Kondensatoren C1 und C2 geschehen. Vielmehr können diese Kondensatoren - wie in FIG 1 strichliert dargestellt - auch zwischen die zweite Eingangsklemme E2 und zweiten Ausgangsklemme oder A2, E2′ und A2′ geschaltet werden, wie dies die Kondensatoren C3 und C4 in FIG 1 zeigen. Weiterhin kann der Kondensator C7, C8 im Differenzverstärker I, II auch zwischen den beiden Ausgangsklemmen A1 und A2 bzw. A1′ und A2′ oder aber zwischen den Eingangsklemmen E1 und E2 bzw. E1′ und E2′ angeordnet werden, wie die strichliert dargestellten Kondensatoren C5, C6 zeigen. Darüber hinaus ist es auch möglich, mehrere der eben erwähnten Möglichkeiten in einem oder beiden der Differenzverstärker I, II vorzusehen.

In der Praxis hat sich jedoch herausgestellt, daß es am günstigsten ist, wenn die Kondensatoren C1 und C2 sowie C4 in der Schmitt-Trigger-Einrichtung 16 vorgesehen werden und die Kapazität des Kondensators C1 der Summe der Kapazitäten der Kondensatoren C2 und C4 entspricht. Die Kapazitäten dieser Kondensatoren C1, C2, C4 sind dabei im pF-Bereich zu wählen. Bevorzugt beträgt die Kapazität des Kondensators C1 4 pF und die Kapazitäten der beiden Kondensatoren C2 und C4 jeweils 2 pF. Bei einer derartigen Schaltungsanordnung stellt sich zwischen dem eingangsseitigen TLL-Signal und ausgangsseitigen ECL-Signal eine maximale Zeitverzögerung ein.

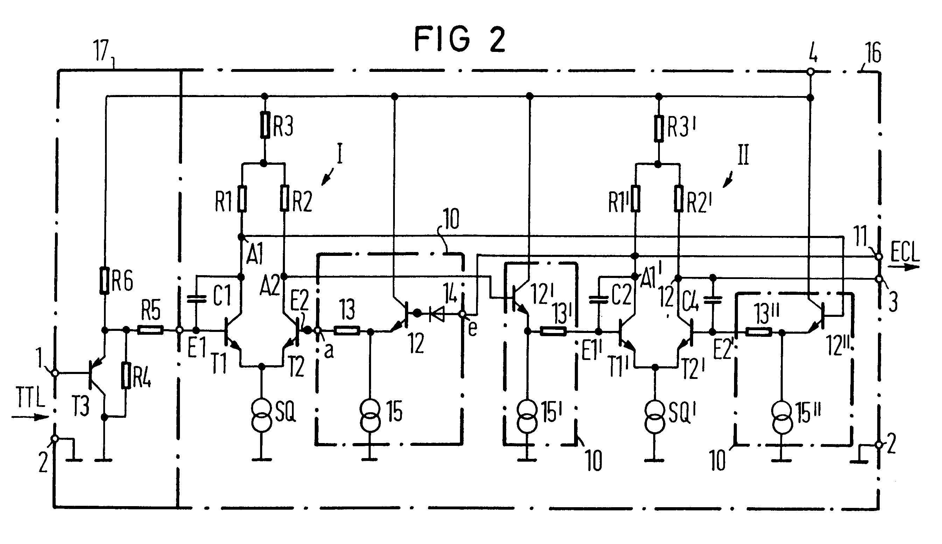

FIG 2 zeigt eine Weiterbildung der Erfindung. Zusätzlich zu der in FIG 1 bereits vorgestellten Schaltungsanordnung sind jetzt auch an die Eingangsklemmen E1′ und E2′ jeweils weitere Einrichtungen 10 zur Pegelverschiebung vorgesehen, um eine Sättigung der Bipolartransistoren T1′ bzw. T2′ zu vermeiden. An der Eingangsklemme E2 dient die Einrichtung 10 dazu den TTL-Schaltpunkt, der bei ca. 2,25 Volt liegt, einzustellen. Eine solche Einrichtung 10 zur Pegelverschiebung, genauer gesagt zur Pegelerniedrigung, weist z. B. eine Kollektorschaltung eines Bipolartransistors 12 auf, dessen Basisanschluß den Eingang e und dessen Emitteranschluß über einen Widerstand 13 den Ausgang a der Einrichtung 10 bildet. Der Verbindungspunkt des Bipolartransistors 12 und Widerstandes 13 ist über eine Stromquelle 15 an Bezugspotential geschaltet. Der Kollektoranschluß des Bipolartransistors 12 ist an den Versorgungspotentialanschluß 4 geschaltet. Darüber hinaus kann zwischen dem Basisanschluß des Bipolartransistors 12 und den Eingang e der Einrichtung 10 eine Diode 14 in Flußrichtung geschaltet sein. Durch eine derartige Pegelverschiebung wird der volle Hysteresehub erreicht.

Darüber hinaus hat es sich noch als günstig erwiesen zwischen den Eingangsanschluß 1 der Schmitt-Trigger-Einrichtung 16 und der ersten Eingangsklemme E1 des ersten Differenzverstärkers I eine Eingangsstufe 17 anzuordnen. Dazu ist der Eingangsanschluß 1 mit dem Basisanschluß eines pnp-Bipolartransistors verbunden, dessen Emitteranschluß über einen Widerstand R6 mit dem Versorgungspotentialanschluß 4 in Verbindung steht und dessen Kollektoranschluß an die Bezugspotentialklemme 2 geschaltet ist. Der Emitteranschluß dieses Bipolartransistors T3 ist zusätzlich über einen weiteren Widerstand R5 mit der ersten Eingangsklemme E1 des Differenzverstärkers I in Verbindung. Die Laststrecke des pnp-Bipolartransistors T3 ist von einem Widerstand R4 überbrückt.

Eine solche Eingangsstufe 17 ist besonders dann von Vorteil, wenn ein I²C-Bus die TTL-Eingangssignale liefert. Die TTL-Eingangssignale liegen dort nämlich zwischen 0 und 5 Volt bei einem Strom von kleiner als 10 µA. Mit den Widerständen R4 und R6 wird erfindungsgemäß eine Spannung an der Eingangsklemme E1 eingestellt, die größer als die Spannung an der Eingangsklemme E2 aber kleiner als die Spannung an der Klemme 4 ist, sodurch der Transistor T1 nicht in die Sättigung kommt.

Ein wesentlicher Vorteil einer derartigen Schaltungsanordnung liegt darin, daß die TTL-Signale am Eingangsanschluß 1 der Schaltungsanordnung in am Ausgangsanschluß 3 abgreifbare ECL-Signale umgewandelt werden . Dabei werden Störsignale, die über der Eckfrequenz von beispielsweise 500 kHz liegen durch den Pegelwandler nicht durchgelassen. Signale, die niederfrequenter als die Eckfrequenz sind, passieren dagegen nahezu unverfälscht die Schaltungsanordnung.

## Patentansprüche

1. Schaltungsanordnung für einen Pegelwandler zum Umwandeln von TTL-Eingangssignalen in ECL-Ausgangssignale
**gekennzeichnet durch** eine Schmitt-Trigger-Einrichtung (16) mit Tiefpaßcharakteristik mit den folgenden Merkmalen:
- Die Schmitt-Trigger-Einrichtung (16) weist einen an Bezugspotential liegenden Bezugspotentialanschluß (2), einen Eingangsanschluß (1) zum Anlegen von TTL-Signalen und mindestens einen Ausgangsanschluß (3, 11) zum Abgreifen von pegelgewandelten ECL-Signalen auf,
- ein erster und zweiter Differenzverstärker (I; II) weisen jeweils eine erste und zweite Eingangsklemme (E1, E2; E1′, E2′), eine erste und zweite Ausgangsklemme (A1, A2; A1′, A2′) sowie zwei mit ihren Emitteranschlüssen an eine mit Bezugspotential verbundene Konstantstromquelle (SQ; SQ′) geschaltete Bipolartransistoren (T1, T2; T1′, T2′) auf, deren Basisanschlüsse mit der ersten oder zweiten Eingangsklemme (E1, E2; E1′, E2′) des jeweiligen Differenzverstärkers (I, II) verbunden sind,
- die Ausgangsklemmen (A1, A2) des ersten Differenzverstärkers (I) sind mit den Eingangsklemmen (E2′, E1′) des zweiten Differenzverstärkers (II) verbunden,
- die erste Eingangsklemme (E1) des ersten Differenzverstärkers (I) ist mit dem Eingangsanschluß (1) verbunden,
- die erste Ausgangsklemme (A1′) des zweiten Differenzverstärkers (II) ist auf die zweite Eingangsklemme (E2) des ersten Differenzverstärkers (1) rückgekoppelt,
- mindestens eine der beiden Ausgangsklemmen (A1′, A2′) des zweiten Differenzverstärkers (II) ist mit dem oder einem der Ausgangsanschlüsse (3, 11) verbunden,
- jeder der beiden Differenzverstärker (I; II) weist zur Erhöhung der Eingangskapazitäten mindestens einen Kondensator (C1, C3, C5, C7; C2, C4, C6, C8) auf und
- zwischen die erste Ausgangsklemme (A1′) des zweiten Differenzverstärkers (II) und die zweite Eingangsklemme (E2) des ersten Differenzverstärkers (I) ist eine Einrichtung (10) zur Pegelverschiebung geschaltet, die in ihrem Eingangs-Ausgangs-Signalpfad die Basis-Emitter-Strecke eines weiteren Bipolartransistors (12) enthält.

2. Schaltungsanordnung nach Anspruch 1,
**dadurch gekennzeichnet**,
daß zwischen die erste Eingangsklemme (E1) und erste Ausgangsklemme (E2) des ersten Differenzverstärkers (I) ein Kondensator (C1) geschaltet ist.

3. Schaltungsanordnung nach Anspruch 1 oder 2,
**dadurch gekennzeichnet**,
daß zwischen die erste Eingangsklemme (E1′) und erste Ausgangsklemme (A1′) des zweiten Differenzverstärkers (II) ein Kondensator (C2) geschaltet ist.

4. Schaltungsanordnung nach einem der Ansprüche 1 bis 3,
**dadurch gekennzeichnet**,
daß zwischen die zweite Eingangsklemme (E2) und zweite Ausgangsklemme (A2) des ersten Differenzverstärkers (I) ein Kondensator (C3) geschaltet ist.

5. Schaltungsanordnung nach einem der Ansprüche 1 bis 4,
**dadurch gekennzeichnet**,
daß zwischen die zweite Eingangsklemme (E2′) und zweite Ausgangsklemme (A2′) des zweiten Differenzverstärkers (II) ein Kondensator (C4) geschaltet ist.

6. Schaltungsanordnung nach Anspruch 1, 3 oder 5,
**dadurch gekennzeichnet**,
daß zwischen die beiden Eingangsklemmen (E1, E2) des ersten Differenzverstärkers (I) ein Kondensator (C5) geschaltet ist.

7. Schaltungsanordnung nach Anspruch 1, 2, 4 oder 6,
**dadurch gekennzeichnet**,
daß zwischen die beiden Eingangsklemmen (E1′, E2′) des zweiten Differenzverstärkers (II) ein Kondensator (C6) geschaltet ist.

8. Schaltungsanordnung nach Anspruch 1, 3, 5 oder 7,
**dadurch gekennzeichnet**,
daß zwischen die beiden Ausgangsklemmen (A1, A2) des ersten Differenzverstärkers (I) ein Kondensator (C7) geschaltet ist.

9. Schaltungsanordnung nach Anspruch 1, 2, 4 oder 6,
**dadurch gekennzeichnet**,
daß zwischen die beiden Ausgangsklemmen (A1′, A2′) des zweiten Differenzverstärkers (II) ein Kondensator (C8) geschaltet ist.

10. Schaltungsanordnung nach einem der Ansprüche 1 bis 9,
**dadurch gekennzeichnet**,
daß an mindestens eine weitere der Eingangsklemmen (E1; E1′, E2′)eines der beiden Differenzverstärker (I, II) eine weitere Einrichtung (10) zur Pegelverschiebung geschaltet ist.

11. Schaltungsanordnung nach Anspruch 10,
**dadurch gekennzeichnet**,
daß die Einrichtungen (10) zur Pegelverschiebung jeweils eine Kollektorschaltung des weiteren Bipolartransistors (12) aufweisen, dessen Basisanschluß den Eingang (e) und dessen Emitteranschluß über einen Widerstand (13) den Ausgang (a) der Einrichtung (10) bildet.

12. Schaltungsanordnung nach Anspruch 11,
**dadurch gekennzeichnet**,
daß zwischen den Eingang (e) und den Basisanschluß des weiteren Bipolartransistors (12) eine Diode (14) in Flußrichtung geschaltet ist.

## Claims

1. Circuit arrangement for a level converter for converting TTL input signals into ECL output signals, characterized by a Schmitt trigger device (16) having low-pass filter characteristics, having the following features:
- the Schmitt trigger device (16) has a reference potential connection (2), which is at reference potential, an input connection (1) for applying TTL signals, and at least one output connection (3, 11) for picking off level-converted ECL signals,
- a first and second differential amplifier (I; II) each have a first and second input terminal (E1, E2; E1′, E2′), a first and second output terminal (A1, A2; A1′, A2′) as well as two bipolar transistors (T1, T2; T1′, T2′), which are connected by their emitter connections to a constant-current source (SQ; SQ′) connected to reference potential and the base connections of which are connected to the first or second input terminal (E1, E2; E1′, E2′) of the respective differential amplifier (I, II),
- the output terminals (A1, A2) of the first differential amplifier (I) are connected to the input terminals (E2′, E1′) of the second differential amplifier (II),
- the first input terminal (E1) of the first differential amplifier (I) is connected to the input connection (1),
- the first output terminal (A1′) of the second differential amplifier (II) is fed back to the second input terminal (E2) of the first differential amplifier (1),
- at least one of the two outputs terminals (A1′, A2′) of the second differential amplifier (II) is connected to the or one of the output connections (3, 11),
- each of the two differential amplifiers (I; II) has at least one capacitor (C1, C3, C5, C7; C2, C4, C6, C8) for the purpose of increasing the input capacitances, and
- a device (10) for level shifting, the input-output signal path of which contains the base-emitter junction of a further bipolar transistor (12), is connected between the first output terminal (A1′) of the second differential amplifier (II) and the second input terminal (E2) of the first differential amplifier (I).

2. Circuit arrangement according to Claim 1, characterized in that a capacitor (C1) is connected between the first input terminal (E1) and first output terminal (E2) of the first differential amplifier (I).

3. Circuit arrangement according to Claim 1 or 2, characterized in that a capacitor (C2) is connected between the first input terminal (E1′) and first output terminal (A1′) of the second differential amplifier (II).

4. Circuit arrangement according to one of Claims 1 to 3, characterized in that a capacitor (C3) is connected between the second input terminal (E2) and second output terminal (A2) of the first differential amplifier (I).

5. Circuit arrangement according to one of Claims 1 to 4, characterized in that a capacitor (C4) is connected between the second input terminal (E2′) and second output terminal (A2′) of the second differential amplifier (II).

6. Circuit arrangement according to Claim 1, 3 or 5, characterized in that a capacitor (C5) is connected between the two input terminals (E1, E2) of the first differential amplifier (I).

7. Circuit arrangement according to Claim 1, 2, 4 or 6, characterized in that a capacitor (C6) is connected between the two input terminals (E1′, E2′) of the second differential amplifier (II).

8. Circuit arrangement according to Claim 1, 3, 5 or 7, characterized in that a capacitor (C7) is connected between the two output terminals (A1, A2) of the first differential amplifier (I).

9. Circuit arrangement according to Claim 1, 2, 4 or 6, characterized in that a capacitor (C8) is connected between the two output terminals (A1′, A2′) of the second differential amplifier (II).

10. Circuit arrangement according to one of Claims 1 to 9, characterized in that a further device (10) for level shifting is connected to at least another of the input terminals (E1; E1′, E2′) of one of the two differential amplifiers (I, II).

11. Circuit arrangement according to Claim 10, characterized in that the devices (10) for level shifting each have a common collector of the further bipolar transistor (12), the base connection of which forms the input (e) and the emitter connection of which forms, via a resistor (13), the output (a) of the device (10).

12. Circuit arrangement according to Claim 11, characterized in that a diode (14) is connected in the flow direction between the input (e) and the base connection of the further bipolar transistor (12).

## Revendications

1. Montage pour un convertisseur de niveau servant à convertir des signaux d'entrée TTL en des signaux de sortie ECL,
caractérisé par un dispositif Trigger de Schmitt (16) ayant une caractéristique de filtre passe-bas et présentant les caractéristiques suivantes :
- le Trigger de Schmitt (16) comporte une borne (2) de potentiel de référence placée à un potentiel de référence, une borne d'entrée (1) pour appliquer des signaux TTL et au moins une borne de sortie (3,11) pour prélever des signaux ECL dont le niveau est converti,
- des premier et second amplificateurs différentiels (I; II) ont chacun des première et seconde bornes d'entrée (E1,E2; E1′,E2′), des première et seconde bornes de sortie (A1,A2; A1′,A2′) ainsi que deux transistors bipolaires (T1,T2;T1′,T2′), qui sont branchés par leurs bornes d'émetteurs à une source de courant constant (SQ; SQ′) reliée au potentiel de référence et dont les bornes de base sont reliées à la première ou à la seconde borne d'entrée (E1,E2;E1′,E2′) de l'amplificateur différentiel respectif (I,II),
- les bornes de sortie (A1,A2) du premier amplificateur différentiel (I) sont reliées aux bornes d'entrée (E2′, E1′) du second amplificateur différentiel (II),
- la première borne d'entrée (E1) du premier amplificateur différentiel (I) est reliée à la borne d'entrée (1),
- la première borne de sortie (E1′) du second amplificateur différentiel (II) est couplée par réaction à la seconde borne d'entrée (E2) du premier amplificateur différentiel (1),
- au moins l'une des deux bornes de sortie (A1′,A2′) du second amplificateur différentiel (II) est reliée à la ou à l'une des bornes de sortie (3,11),
- chacun des deux amplificateurs différentiels (I;II) a, pour accroître les capacités d'entrée, au moins un condensateur (C1,C3,C5,C7; C2,C4,C6,C8) et
- entre la première borne de sortie (E1′) du second amplificateur différentiel (II) et la seconde borne d'entrée (E2) du premier amplificateur différentiel (I) est branché un dispositif (10) de décalage de niveau, qui contient, dans sa voie entrée - sortie de transmission du signal, la section base - émetteur d'un autre transistor bipolaire (12).

2. Montage suivant la revendication 1, caractérisé par le fait qu'un condensateur (C1) est branché entre la première borne d'entrée (E1) et la première borne de sortie (E2) du premier amplificateur différentiel (I).

3. Montage suivant la revendication 1 ou 2, caractérisé par le fait qu'un condensateur (C2) est branché entre la première borne d'entrée (E1′) et la première borne de sortie (A1′) du second amplificateur différentiel (II).

4. Montage suivant l'une des revendications 1 à 3, caractérisé par le fait qu'un condensateur (C3) est branché entre la seconde borne d'entrée (E2) et la seconde borne de sortie (A2) du premier amplificateur différentiel (I).

5. Montage suivant l'une des revendications 1 à 4, caractérisé par le fait qu'un condensateur (C4) est branché entre la seconde borne d'entrée (E2′) et la seconde borne de sortie (A2′) du second amplificateur différentiel (II).

6. Montage suivant la revendication 1, 3 ou 5, caractérisé par le fait qu'un condensateur (C5) est branché entre les deux bornes d'entrée (E1,E2) du premier amplificateur différentiel (I).

7. Montage suivant l'une des revendications 1, 2, 4 ou 6, caractérisé par le fait qu'un condensateur (C6) est branché entre les deux bornes d'entrée (E1′,E2′) du second amplificateur différentiel (II).

8. Montage suivant la revendication 1, 3, 5 ou 7, caractérisé par le fait qu'un condensateur (C7) est branché entre les deux bornes de sortie (A1,A2) du premier amplificateur différentiel (I).

9. Montage suivant la revendication 1, 2, 4 ou 6, caractérisé par le fait qu'un condensateur (C8) est branché entre les deux bornes de sortie (A1′;A2′) du second amplificateur différentiel (II).

10. Montage suivant l'une des revendications 1 à 9, caractérisé par le fait qu'un autre dispositif (10) de décalage de niveau est branché à au moins une autre des bornes d'entrée (E1;E1′;E2′) de l'un des deux amplificateurs différentiels (I,II).

11. Montage suivant la revendication 10, caractérisé par le fait que les dispositifs (10) de décalage de niveau ont chacun un circuit collecteur de l'autre transistor bipolaire (12), dont la borne de base forme l'entrée (e) et dont la borne d'émetteur forme, par l'intermédiaire d'une résistance (13), la sortie (a) du dispositif (10).

12. Montage suivant la revendication 11, caractérisé par le fait qu'une diode (14) est branchée dans le sens passant entre l'entrée (e) et la borne de base de l'autre transistor bipolaire (12).
